# EUROPEAN PATENT APPLICATION

(11) **EP 4 294 140 A1**
(43) Date of publication of application: **20.12.2023**
(21) Application number: 22767431.4
(22) Date of filing: 07.03.2022
(51) Int. Cl.: H05K 9/00, H05K 5/00, H05K 5/04, H04M 1/02, H01Q 1/24, H01R 24/60

(54) **ELECTRONIC APPARATUS INCLUDING ANTENNA**

(30) Priority: 12.03.2021 KR 20210032979
(71) Applicant: Samsung Electronics Co., Ltd., Suwon-si, Gyeonggi-do 16677 (KR)
(72) Inventor: KIM, Jonghoon, Suwon-si Gyeonggi-do 16677 (KR); KIM, Jaehyung, Suwon-si Gyeonggi-do 16677 (KR); CHOI, Sanghoon, Suwon-si Gyeonggi-do 16677 (KR); OH, Dongjun, Suwon-si Gyeonggi-do 16677 (KR); JEONG, Myunghun, Suwon-si Gyeonggi-do 16677 (KR)
(74) Representative: HGF
(86) International application number: PCT/KR2022/003152
(87) International publication number: WO 2022/191535

(57) **Abstract**

Various embodiments of the present invention provide an electronic device including an antenna, the electronic device comprising: a housing that has a first segment, a second segment, and a conductive section formed between the first segment and the second segment; a support member located inside the housing and including at least one of a metal material and a non-conductive member; a display disposed on a first surface of the support member; a printed circuit board disposed on a second surface of the support member and including at least one through-hole; a processor disposed on the printed circuit board and electrically connected to the conductive section; at least one fastening member disposed on the non-conductive member and including a fastening hole; and a shielding member which has an opening and is located between the display and the support member. The opening may be formed such that the shielding member and the at least one fastening member are not electrically connected. Various other embodiments are possible.

## Description

### [Technical Field]

Various embodiments of the disclosure relate to an electronic device including an antenna.

### [Background Art]

There has been increasing use of electronic devices such as bar-type, foldable-type, rollable-type, or sliding-type smartphones or tablet PCs, and various functions are provided to electronic devices.

An electronic device may transmit and receive various pieces of data with another electronic device, in addition to making a phone call, through wireless communication.

The electronic device may include at least one antenna to perform wireless communication with another electronic device by using a network.

### [Disclosure of Invention]

### [Technical Problem]

At least a part of a housing that constitutes the exterior of an electronic device may be made of a conductive material (for example, metal).

At least a part of the housing, which is made of a conductive material, may be used as an antenna (for example, antenna radiator) for performing wireless communication. The housing of an electronic device may include at least one antenna separated by at least one segmented portion (for example, slit).

If the electronic device has a conductive shielding member disposed to overlap at least a part of the antenna (for example, antenna radiator) or to be adjacent thereto, parasitic resonance may occur in the antenna. If parasitic resonance occurs in the antenna, the radiation performance of the antenna may be degraded, or a deviation may occur in the frequency band.

If the radiation performance of the antenna is degraded, or if a deviation occurs in the frequency band, the electronic device may fail to normally perform telephone communication and/or data transmission/reception with another electronic device.

Various embodiments of the disclosure may provide an electronic device including an antenna, wherein an opening is formed in a conductive shielding member such that the occurrence of parasitic resonance is reduced, thereby preventing degradation of the radiation performance, and reducing the occurrence of a deviation in the frequency band.

Technical problems to be solved by the disclosure are not limited to the above-mentioned technical problems, and other technical problems not mentioned herein will be clearly understood from the following description by those skilled in the art to which the disclosure pertains.

### [Solution to Problem]

An electronic device according to various embodiment of the disclosure may include a housing having a first segment part and a second segment part formed therein and including a conductive portion formed between the first segment part and the second segment part, a support member disposed inside the housing and including at least one of a metal material and a non-conductive member, a display disposed on a first surface of the support member, a printed circuit board disposed on a second surface of the support member and including at least one through-hole, a processor disposed on the printed circuit board and electrically connected to the conductive portion, at least one fastening member disposed in the non-conductive member and including a fastening hole, and a shield member disposed between the display and the support member and having an opening part formed therein, wherein the opening part is formed such that the shield member and the at least one fastening member are not electrically connected.

An electronic device according to various embodiment of the disclosure may include a housing having a first segment part and a second segment part formed therein and including a conductive portion formed between the first segment part and the second segment part, a support member disposed inside the housing and including at least one of a metal material and a non-conductive member, a display disposed on a first surface of the support member, a printed circuit board disposed on a second surface of the support member and including at least one through-hole, a processor disposed on the printed circuit board and electrically connected to the conductive portion, at least one fastening member disposed on the non-conductive member and including a fastening hole, and a shield member disposed between the display and the support member and having an opening part formed therein, wherein the opening part is formed such that the shield member and the at least one fastening member are not electrically connected, wherein the at least one through-hole formed through the printed circuit board and the fastening hole formed through the at least one fastening member are coupled using a fixation member, wherein a current flowing in a first direction along the printed circuit board flows in a second direction through the fixation member, and wherein a current delivered through the fixation member flows in a direction substantially the same as the first direction by the opening part formed in the shield member to be delivered to the conductive portion.

### [Advantageous Effects of Invention]

Various embodiments of the disclosure may provide an electronic device wherein a part of a shielding member is removed so as to form an opening, and the opening is used to prevent the shielding member and a screw fastening member from overlapping or from being electrically connected to each other such that the occurrence of parasitic resonance in an antenna is reduced, thereby preventing degradation of the radiation performance of the antenna, and reducing the occurrence of a deviation in the frequency band.

Various other advantages effects identified explicitly or implicitly through the disclosure may be provided.

### [Brief Description of Drawings]

In connection with the description of the drawings, same or similar reference numerals will be used to refer to same or similar elements.
FIG. 1 is a block diagram of an electronic device in a network environment according to various embodiments of the disclosure.
FIG. 2A is a front perspective view of an electronic device according to various embodiments of the disclosure.
FIG. 2B is a rear perspective view of an electronic device according to various embodiments of the disclosure.
FIG. 3 is an exploded perspective view of an electronic device according to various embodiments of the disclosure.
FIG. 4 is an exploded perspective view schematically showing an electronic device including an antenna according to various embodiments of the disclosure.
FIG. 5A is a plan view schematically showing a part of the electronic device in FIG. 4 according to various embodiments of the disclosure.
FIG. 5B is a view showing various shapes of an opening part formed in a shield member according to various embodiments of the disclosure.
FIG. 6A is a view showing a schematic cross-section of the electronic device taken along line A-A' in FIG. 5A and a current flow according to various embodiments of the disclosure.
FIG. 6B is a view showing a simulation result of the distribution of a current flow of the electronic device illustrated in FIG. 6A according to various embodiments of the disclosure.
FIG. 7 is a view showing a radiation efficiency of an electronic device according to various embodiments of the disclosure and a radiation efficiency of an electronic device according to a comparative embodiment.
FIG. 8 is a view showing a reflection coefficient of an electronic device according to various embodiments of the disclosure and a reflection coefficient of an electronic device according to a comparative embodiment.
FIG. 9A is a view showing a VSWR simulation result of an electronic device according to a comparative embodiment.
FIG. 9B is a view showing a VSWR simulation result of an electronic device according to various embodiments of the disclosure.

### [Mode for the Invention]

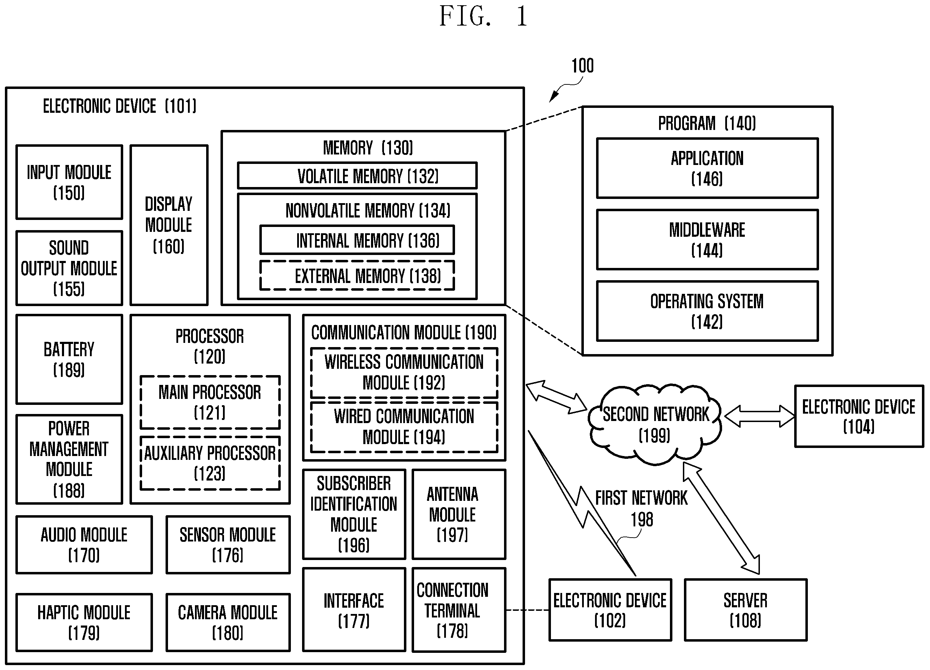

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

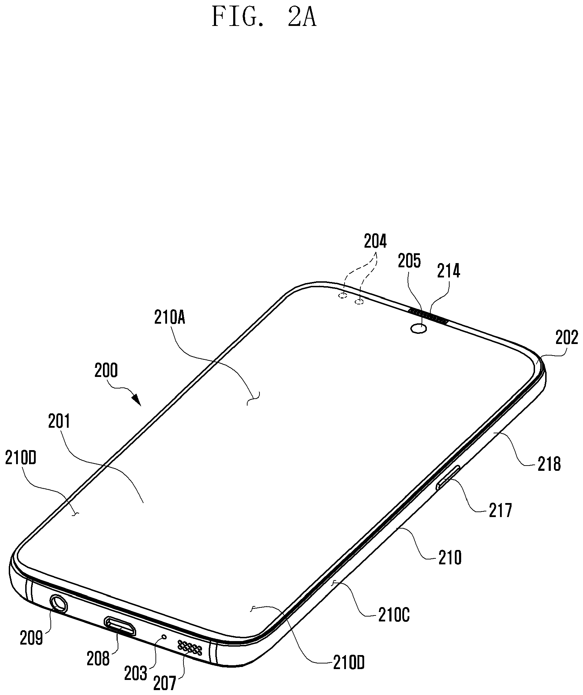

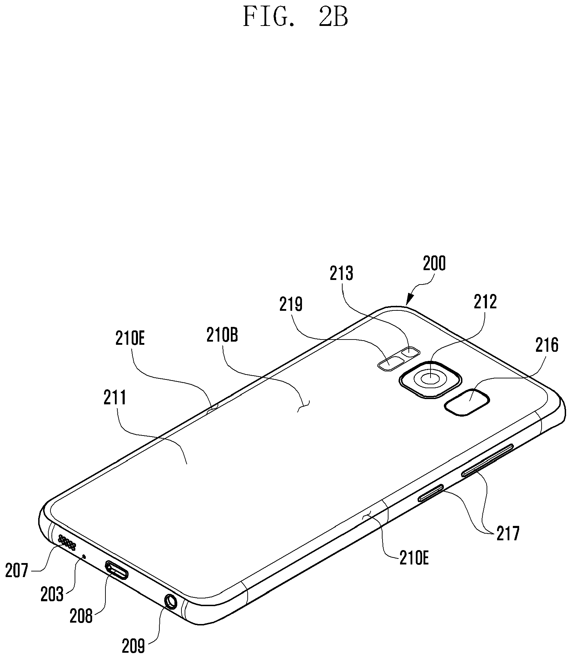

FIG. 2A is a front perspective view of an electronic device according to various embodiments of the disclosure. FIG. 2B is a rear perspective view of the electronic device in FIG. 2A according to various embodiments of the disclosure.

Referring to FIG. 2A and FIG. 2B, an electronic device 200 according to an embodiment may include a housing 210 including a first surface (or front surface) 210A, a second surface (or rear surface) 210B, and a side surface 210C surrounding the space between the first surface 210A and the second surface 210B. In another embodiment (not illustrated), the housing may denote a structure that forms a part of the first surface 210A, the second surface 210B, and the side surface 210C illustrated in FIG. 2A and FIG. 2B. According to an embodiment, the first surface 210A may be formed by a front plate 202, at least a part of which is substantially transparent (for example, a glass plate including various coating layers, or a polymer plate). The second surface 210B may be formed by a rear plate 211 that is substantially opaque. The rear plate 211 may be made of coated or colored glass, ceramic, polymer, metal (for example, aluminum, stainless steel (STS), or magnesium), or a combination of at least two of the above-mentioned materials. The side surface 210C may be formed by a side bezel structure (or "side member") 218 which is coupled to the front plate 202 and to the rear plate 211, and which includes metal and/or polymer. In some embodiments, the rear plate 211 and the side bezel structure 218 may be formed integrally and may include the same material (for example, a metal material such as aluminum).

In the illustrated embodiment, the front plate 202 may include two first areas 210D on both ends of the long edge of the front plate 202 such that the two first areas 210D bend from the first surface 210A toward the rear plate 211 and extend seamlessly. In the illustrated embodiment (see FIG. 2B), the rear plate 211 may include two second areas 210E on both ends of the long edge such that the two second areas 210E bend from the second surface 210B toward the front plate 202 and extend seamlessly. In some embodiments, the front plate 202 (or the rear plate 211) may include only one of the first areas 210D (or the second areas 210E). In another embodiment, a part of the first areas 210D or the second areas 210E may not be included. In the above embodiments, when seen from the side surface of the electronic device 200, the side bezel structure 218 may have a first thickness (or width) on a part of the side surface, which does not include the first areas 210D or the second areas 210E as described above, and may have a second thickness that is smaller than the first thickness on a part of the side surface, which includes the first areas 210D or the second areas 210E.

According to an embodiment, the electronic device 200 may include at least one of a display 201, audio modules 203, 207, and 214, sensor modules 204, 216, and 219, camera modules 205, 212, and 313, a key input device 217, a light-emitting element 206, and connector holes 208 and 209. In some embodiments, at least one of the constituent elements (for example, the key input device 217 or the light-emitting element 206) of the electronic device 200 may be omitted, or the electronic device 200 may additionally include another constituent element.

The display 201 may be exposed through a corresponding part of the front plate 202, for example. In some embodiments, at least a part of the display 201 may be exposed through the front plate 202 that forms the first areas 210D of the side surface 210C and the first surface 210A. In some embodiments, the display 201 may have a corner formed in substantially the same shape as that of the adjacent outer periphery of the front plate 202. In another embodiment (not illustrated), in order to increase the area of exposure of the display 201, the interval between the outer periphery of the display 201 and the outer periphery of the front plate 202 may be formed to be substantially identical.

The audio modules 203, 207, and 214 may include a microphone hole 203 and speaker holes 207 and 214. A microphone for acquiring an external sound may be arranged in the microphone hole 203, and a plurality of microphones may be arranged therein such that the direction of a sound can be sensed in some embodiments. The speaker holes 207 and 214 may include an outer speaker hole 207 and a speech receiver hole 214. In some embodiments, the speaker holes 207 and 214 and the microphone hole 203 may be implemented as a single hole, or a speaker may be included (for example, a piezoelectric speaker) without the speaker holes 207 and 214.

The sensor modules 204, 216, and 219 may generate an electric signal or a data value corresponding to the internal operating condition of the electronic device 200 or the external environment condition thereof. The sensor modules 204, 216, and 219 may include, for example, a first sensor module 204 (for example, a proximity sensor) arranged on the first surface 210A of the housing 210, and/or a second sensor module (not illustrated) (for example, a fingerprint sensor), and/or a third sensor module 219 (for example, an HRM sensor) arranged on the second surface 210B of the housing 210, and/or a fourth sensor module 216 (for example, a fingerprint sensor). The fingerprint sensor may be arranged not only on the first surface 210A (for example, the display 201) of the housing 210, but also on the second surface 210B thereof. The electronic device 200 may further include a sensor module not illustrated, for example, at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or a luminance sensor 204.

The camera modules 205, 212, and 213 may include a first camera device 205 arranged on the first surface 210A of the electronic device 200, a second camera device 212 arranged on the second surface 210B thereof, and/or a flash 213. The camera devices 205 and 212 may include a single lens or a plurality of lenses, an image sensor, and/or an image signal processor. The flash 213 may include, for example, a light-emitting diode or a xenon lamp. In some embodiments, two or more lenses (an infrared camera, a wide-angle lens, and a telephoto lens) and image sensors may be arranged on a single surface of the electronic device 200.

The key input device 217 may be arranged on the side surface 210C of the housing 210. In another embodiment, the electronic device 200 may not include a part of the above-mentioned key input device 217 or the entire key input device 217, and the key input device 217 (not included) may be implemented in another type, such as a soft key, on the display 201. In some embodiments, the key input device may include a sensor module 216 arranged on the second surface 210B of the housing 210.

The light-emitting element 206 may be arranged on the first surface 210A of the housing 210, for example. The light-emitting element 206 may provide information regarding the condition of the electronic device 200 in a light type, for example. In another embodiment, the light-emitting element 206 may provide a light source that interworks with operation of the camera module 205, for example. The light-emitting element 206 may include, for example, an LED, an IR LED, and a xenon lamp.

The connector holes 208 and 209 may include a first connector hole 208 capable of containing a connector (for example, a USB connector) for transmitting/receiving power and/or data to/from an external electronic device, and/or a second connector hole (for example, an earphone jack) 209 capable of containing a connector for transmitting/receiving an audio signal to/from the external electronic device.

In another embodiment (not illustrated), a recess or an opening may be formed in a part of the screen display area of the display 201, and at least one of an audio module 214, a sensor module 204, a camera module 205, and a light-emitting element 206 may be included and aligned with the recess or the opening. In another embodiment (not illustrated), on the back surface of the screen display area of the display 201, at least one of an audio module 214, a sensor module 204, a camera module 205, a fingerprint sensor 216, and a light-emitting element 206 may be included. In another embodiment (not illustrated), the display 201 may be coupled to or arranged adjacent to a touch sensing circuit, a pressure sensor capable of measuring the intensity (pressure) of a touch, and/or a digitizer that detects a magnetic field-type stylus pen. In some embodiments, at least a part of the sensor modules 204 and 219 and/or at least a part of the key input device 217 may be arranged in the first areas 210D and/or the second areas 210E.

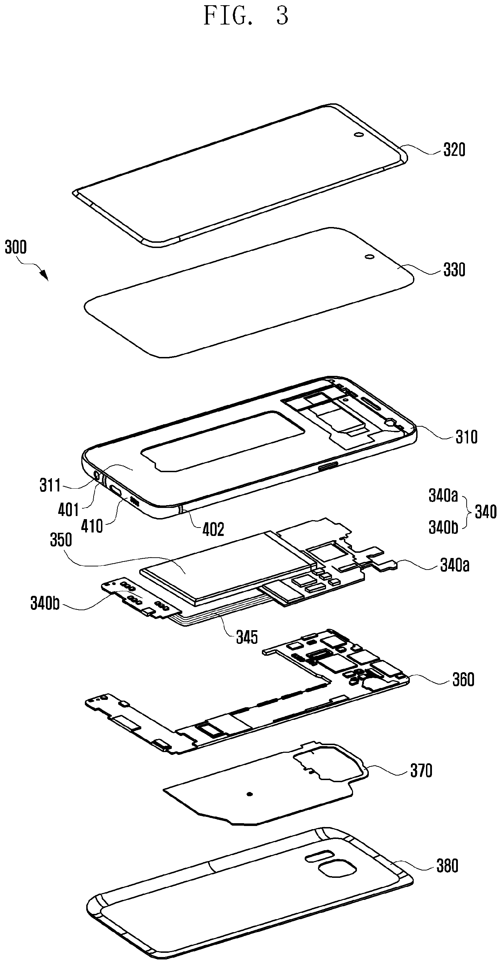

FIG. 3 is an exploded perspective view of the electronic device according to various embodiments of the disclosure.

An electronic device 300 of FIG. 3 includes the electronic device 101 of FIG. 1 and/or the electronic device 200 of FIG. 2.

Referring to FIG. 3, the electronic device 300 may include a side bezel structure 310, a first support member 311 (for example, a bracket), a front plate 320, a display 330, a printed circuit board 340, a battery 350, a second support member 360 (for example, a rear case), an antenna 370, and a rear plate 380. In some embodiments, at least one of the constituent elements (for example, the first support member 311 or the second support member 360) of the electronic device 300 may be omitted, or the electronic device 300 may further include another constituent element. At least one of the constituent elements of the electronic device 300 may be identical or similar to at least one of the constituent elements of the electronic device 101 or 200 of FIG. 1 to FIG. 2B, and repeated descriptions thereof will be omitted herein.

The first support member 311 may be arranged inside the electronic device 300 and connected to the side bezel structure 310, or may be formed integrally with the side bezel structure 310. The first support member 311 may be made of a metal material and/or a nonmetal (for example, polymer) material, for example. The display 330 may be coupled to one surface of the first support member 311, and the printed circuit board 340 may be coupled to the other surface thereof.

A processor, a memory, and/or an interface may be mounted on the printed circuit board 340. The processor may include, for example, one or more of a central processing device, an application processor, a graphic processing device, an image signal processor, a sensor hub processor, or a communication processor.

According to various embodiments, the printed circuit board 340 may include a first PCB 340a and/or a second PCB 340b. For example, the first PCB 340a and the second PCB 340b may be spaced apart from each other and be electrically connected using a connection member 345 (e.g., a coaxial cable and/or an FPCB). As another example, the printed circuit board 340 may include a structure in which multiple printed circuit boards (PCBs) are stacked each other. The printed circuit board 340 may include an interposer structure. The printed circuit board 340 may be implemented in the form of a flexible printed circuit board (FPCB) and/or a rigid printed circuit board (PCB).

The memory may include a volatile memory or a non-volatile memory, for example.

The interface may include, for example, a high definition multimedia interface (HDMI), a universal serial bus (USB) interface, an SD card interface, and/or an audio interface. The interface may connect the electronic device 300 with an external electronic device electrically or physically, for example, and may include a USB connector, an SD card/MMC connector, or an audio connector.

The battery 350 is a device for supplying power to at least one constituent element of the electronic device 300, and may include a non-rechargeable primary cell, a rechargeable secondary cell, or a fuel cell, for example. At least a part of the battery 350 may be arranged on substantially the same plane with the printed circuit board 340, for example. The battery 350 may be arranged integrally inside the electronic device 300, or may be arranged such that the same can be attached to/detached from the electronic device 300.

The antenna 370 may be arranged between the rear plate 380 and the battery 350. The antenna 370 may include, for example, a near field communication (NFC) antenna, a wireless charging antenna, and/or a magnetic secure transmission (MST) antenna. The antenna 370 may conduct near-field communication with an external device or may wirelessly transmit/receive power necessary for charging, for example. In another embodiment, an antenna structure may be formed by a part or a combination of the side bezel structure 310 and/or the first support member 311.

According to an embodiment, the housing 310 may form the exterior of the electronic device 300. For example, the housing 310 may include a conductive portion 410 (e.g., an antenna radiator) physically separated by a first segment part 401 and a second segment part 402. The conductive portion 410 (e.g., an antenna radiator) may be electrically connected to the processor 120 and/or the wireless communication module 192 illustrated in FIG. 1 and may operate as an antenna radiator.

According to various embodiments, the housing 310 of the electronic device 300 is not limited to the above-described conductive portion 410, and may include more conductive portions according to the number of segment parts.

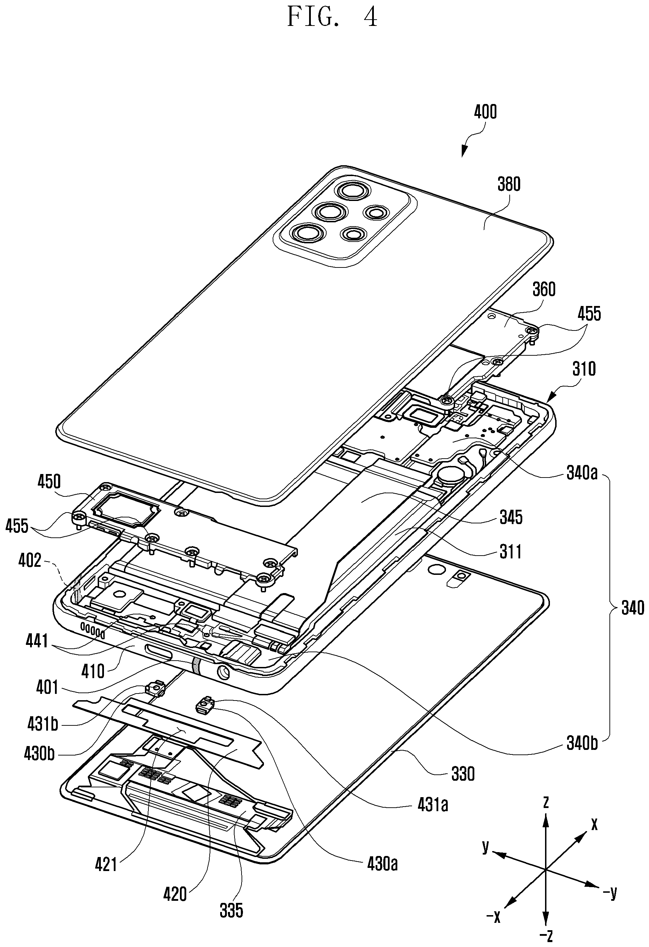

FIG. 4 is an exploded perspective view schematically showing an electronic device including an antenna according to various embodiments of the disclosure.

An electronic device 400 in FIG. 4 may include embodiments of the electronic device 101 described in FIG. 1, the electronic device 200 described in FIG. 2A and FIG. 2B, and/or the electronic device 300 described in FIG. 3. In the description of FIG. 4, the same reference numerals are assigned to elements substantially the same as those of the embodiment of the electronic device 300 illustrated in FIG. 3, and redundant descriptions may be omitted.

In an embodiment, although the embodiment related to the electronic device 400 in FIG. 4 shows a bar-type electronic device, it is not limited thereto, and it may also be applied to electronic device such as a foldable type electronic device, a rollable type electronic device, a sliding type electronic device, a wearable type, a tablet PC, or a notebook PC.

Referring to FIG. 4, the electronic device 400 according to various embodiments of the disclosure may include a housing 310 including a first support member 311, a display 330, a shield member 420, at least one fastening member 430a or 430b, a printed circuit board 340, a dielectric structure 450, a second support member 360, and/or a rear plate 380.

According to an embodiment, the housing 310 may form the exterior of the electronic device 400. For example, the housing 310 may include a conductive portion 410 (e.g., an antenna radiator) formed between a first segment part 401 (e.g., a first non-conductive portion) and a second segment part 402 (e.g., a second non-conductive portion) which are formed on the side-surface part thereof. The conductive portion 410 (e.g., an antenna radiator) may be electrically connected to the processor 120 and/or the wireless communication module 192 illustrated in FIG. 1, and may operate as an antenna.

According to various embodiments, an antenna including at least a part of the conductive portion 410 may operate in the frequency band of a low band (e.g., about 600 MHz - 1200 MHz), a mid-band (e.g., about 1500 MHz - 2200 MHz), and/or a high band (e.g., about 2300 MHz - 2700 MHz). The frequency band of the antenna is not limited to the above-described example, and the antenna may also transmit and receive signals of other frequency bands.

According to an embodiment, the housing 310 may include the first support member 311 disposed to cross the inside thereof. The first support member 311 may be disposed inside the housing 310. The first support member 311 may be disposed inside the electronic device 400 to be connected to the housing 310, or may be integrally formed with the housing 310. For example, the first support member 311 may include a metal material and/or a non-metal (e.g., polymer) material. In an embodiment, the display 330 may be disposed on a first surface (e.g., the surface in the -z-axis direction) of the first support member 311. As another example, the printed circuit board 340 may be disposed on a second surface (e.g., the surface in the z-axis direction) of the first support member 311. In an embodiment, the printed circuit board 340 may include a first PCB 340a and/or a second PCB 340b.

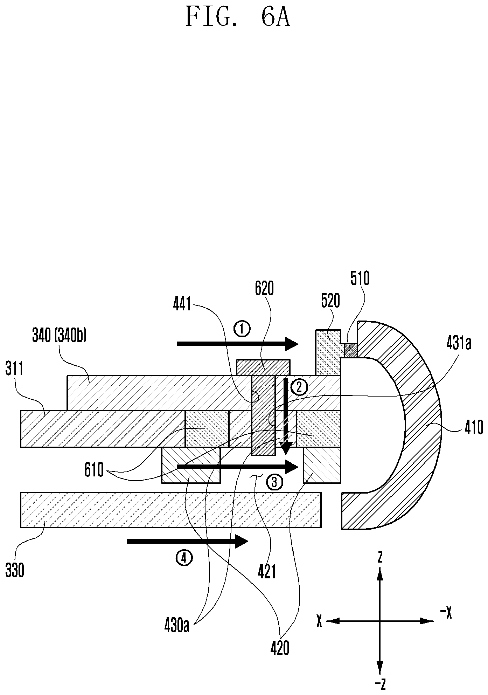

According to an embodiment, the first support member 311 may include at least one fastening member (e.g., the first fastening member 430a and/or the second fastening member 430b). For example, the first support member 311 may be configured such that the first fastening member 430a and/or the second fastening member 430b is disposed in a non-conductive member (e.g., the non-conductive member 610 in FIG. 6A) formed of a non-metal (e.g., polymer) material.

According to various embodiments, the first support member 311 may include a structure for supporting the display 330, the shield member 420, at least one fastening member (e.g., the first fastening member 430a and/or the second fastening member 430b), the printed circuit board 340, the dielectric structure 450, the second support member 360, and/or the rear plate 380 disposed in the housing 310.

According to an embodiment, the display 330 may be disposed on the first surface (e.g., the surface in the -z-axis direction) of the first support member 311. The display 330 may visually provide various information to a user of the electronic device 400. The display 330 may be electrically connected to the printed circuit board 340. The display 330 may include a display circuit part 335 for driving and controlling the display 330 in order to provide various information. The display circuit part 335 may be disposed on the lower part (e.g., the surface in the -x-axis direction) of the display 330. The display 330 may perform an input function and a display function. To this end, the display 330 may include a touch panel and a display part.

According to an embodiment, the shield member 420 may be disposed between the display 330 and the support member 311. The shield member 420 may be disposed adjacent to the conductive portion 410. In an embodiment, the shield member 420 may include an opening part 421. When seen in the z-axis direction, the opening part 421 may be formed such that the shield member 420 and at least one fastening member (e.g., the first fastening member 430a and/or the second fastening member 430b) do not overlap. For example, the opening part 421 may be formed such that the shield member 420 and at least one fastening member (e.g., the first fastening member 430a and/or the second fastening member 430b) are not electrically connected.

In an embodiment, although an example, in which the opening part 421 is formed in a designated shape (e.g., a T-shape), is illustrated, it is not limited thereto, and the opening part may also be formed in various other shapes capable of preventing the shield member 420 and at least one fastening member (e.g., the first fastening member 430a and/or the second fastening member 430b) from overlapping or from being electrically connected.

According to various embodiments, in case that the shield member 420 and at least one fastening member (e.g., first fastening member 430a and/or the second fastening member 430b) are configured so as not to overlap each other by using the opening part 421, the electronic device 400 may be configured to reduce the occurrence of parasitic resonance in the frequency band of a mid-band (e.g., about 1500 MHz - 2200 MHz) and/or a high band (e.g., about 2300 MHz - 2700 MHz) of the conductive portion 410, and thus it may be possible to reduce the degradation of radiation performance of an antenna including the conductive portion 410 and to reduce the occurrence of deviation in the frequency band of the mid-band and/or high-band.

According to various embodiments, the shield member 420 may shield electromagnetic waves generated from the printed circuit board 340 (e.g., the second PCB 340b). The shield member 420 may prevent noise generated from the conductive portion 410 from spreading into the electronic device 400. The shield member 420 may shield electromagnetic waves generated from the display 330 (e.g., display circuit part 335) and/or the printed circuit board 340 (e.g., the second PCB 340b). The shield member 420 may shield electromagnetic interference between the display 330 (e.g., the display circuit part 335) and the printed circuit board 340 (e.g., the second PCB 340b). For example, in case that a USB connector (e.g., a USB cable) is connected to a connection terminal (e.g., the connection terminal 178 in FIG. 1) or a camera module (e.g., the camera module 180 in FIG. 1) is turned on, the shield member 420 may shield parasitic radiation and/or noise which may be generated in the conductive portion 410.

According to various embodiments, the shield member 420 may include a conductive material. For example, the shield member 420 may include a thin-film sheet or plate made of copper (Cu) or graphite. In an embodiment, at least a part of the shield member 420 may be connected to the conductive portion 410 and/or the display 330, and may also perform a ground function of the conductive portion 410 and/or the display 330. For example, the shield member 420 may include a shield can.

According to an embodiment, the at least one fastening member (e.g., the first fastening member 430a and/or the second fastening member 430b) may be disposed in the first support member 311. The first support member 311 may include a first fastening member 430a and/or a second fastening member 430b. For example, the first fastening member 430a and/or the second fastening member 430b may be formed of a conductive material (e.g., metal). The first fastening member 430a and/or the second fastening member 430b may be disposed in a non-conductive member (e.g., the non-conductive member 610 in FIG. 6A) formed in at least a part of the first support member 311. The first fastening member 430a may include a first fastening hole 431a. The second fastening member 430b may include a second fastening hole 431b. A fixation member (e.g., the fixation member 620 in FIG. 6A) may be coupled to the first fastening hole 431a of the first fastening member 430a and/or the second fastening hole 431b of the second fastening member 430b. At least one fastening hole (e.g., the first fastening hole 431a and/or the second fastening hole 431b) and the fixation member 620 may be coupled using a screw coupling manner. The fixation member 620 may include a conductive screw or a bolt. At least one fastening member (e.g., the first fastening member 430a and/or the second fastening member 430b) may be disposed in the opening part 421 formed inside the shield member 420. The end of the fixation member (e.g., the fixation member 620 in FIG. 6A) may be disposed in the opening part 421 of the shield member 420. For example, the fixation member (e.g., the fixation member 620 in FIG. 6A) may not be electrically connected to the shield member 420.

According to an embodiment, the printed circuit board 340 (e.g., the first PCB 340a or the second PCB 340b) may be disposed on a second surface (e.g., the surface in the z-axis direction) of the first support member 311. The printed circuit board 340 may include a through-hole 441 at a portion corresponding to at least one fastening hole (e.g., first fastening hole 431a and/or second fastening hole 431b) of the at least one fastening member (e.g., the first fastening member 430a and/or the second fastening member 430b). The printed circuit board 340 may include the at least one through-hole 441. For example, the number of the at least one through-hole 441 may be formed to correspond to the number of at least one fastening hole (e.g., the first fastening hole 431a and/or the second fastening hole 431b). A fixation member (e.g., the fixation member 620 in FIG. 6A) (e.g., a screw or a bolt) may be fastened to at least one fastening member (e.g., the first fastening member 430a and/or the second fastening member 430b) formed in the first support member 311 through the at least one through-hole 441, and thus the printed circuit board 340 may be coupled to the first support member 311.

According to various embodiments, the printed circuit board 340 may include the first PCB 340a (e.g., a main printed circuit board) disposed in a first direction (e.g., the x-axis direction) and the second PCB 340b (e.g., a sub-printed circuit board) disposed in a second direction (e.g., the -x-axis direction) of the electronic device 400. The second PCB 340b (e.g., a sub-printed circuit board) may be disposed adjacent to the conductive portion 410. For example, when seen in the z-axis direction, at least a part of the second PCB 340b (e.g., a sub-printed circuit board) may be disposed to overlap the shield member 420. The second PCB 340b may include the at least one through-hole 441 described above. The first PCB 340a and the second PCB 340b may be electrically connected through at least one connection member 345. For example, the at least one connection member 345 may include a coaxial cable, a flexible printed circuit board (FPCB), and/or an FPCB type RF cable (FRC).

According to an embodiment, the dielectric structure 450 may be disposed on one surface (e.g., the surface in the z-axis direction) of the second PCB 340b. The dielectric structure 450 may include a structure (e.g., an enclosure) including an antenna carrier and/or an electronic component (e.g., the sound output module 155 and/or the audio module 170 in FIG. 1). The dielectric structure 450 may be coupled to at least one through-hole (not shown) formed through the first support member 311 by using at least one coupling member 455 (e.g., a screw or a bolt).

According to an embodiment, the second support member 360 (e.g., the second support member 360 in FIG. 3) may be disposed on one surface (e.g., the surface of the z-axis direction) of the first PCB 340a. The second support member 360 may protect or support electronic components (e.g., the first PCB 340a) arranged inside the electronic device 400. The second support member 360 may be coupled to at least one through-hole (not shown) formed through the first support member 311 by using the at least one coupling member 455 (e.g., a screw or a bolt).

According to an embodiment, the rear plate 380 may be disposed on the rear surface (e.g., the surface of the z-axis direction) of the electronic device 400. The rear plate 380 may protect the rear surface of the electronic device 400.

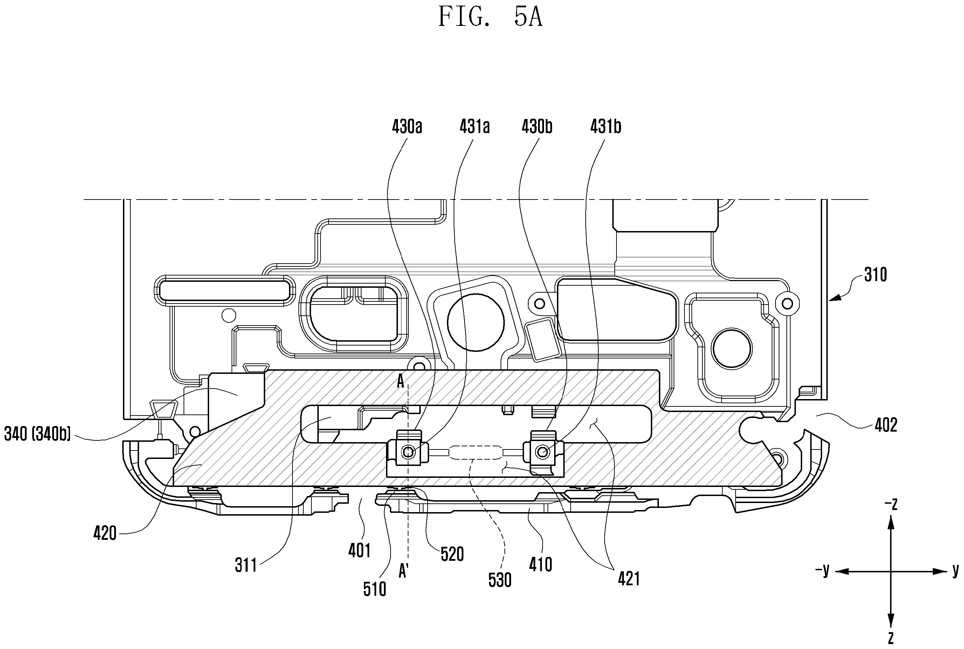

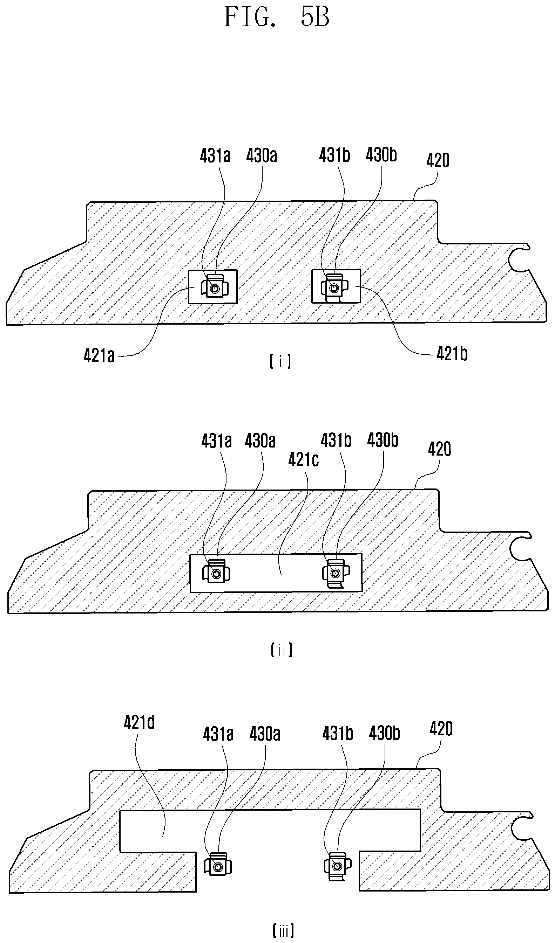

FIG. 5A is a plan view schematically showing a part of the electronic device in FIG. 4 according to various embodiments of the disclosure. FIG. 5B is a view schematically showing various shapes of an opening part formed in a shield member according to various embodiments of the disclosure.

FIG. 5A is a plan view seen in the direction (e.g., the -z-axis direction) of one surface thereof after the display 330 is removed in the electronic device 400 illustrated in FIG. 4. In the description of the embodiments disclosed below, the same reference numerals are assigned to elements substantially the same as those of the electronic device 300 illustrated in FIG. 3 and/or the electronic device 400 illustrated in FIG. 4, and redundant descriptions may be omitted.

Referring to FIG. 5A, a housing 310 may include a conductive portion 410 (e.g., an antenna radiator) formed between a first segment part 401 and a second segment part 402.

According to an embodiment, the conductive portion 410 may include a protruding part 510 formed on a part of the inside thereof. The protruding part 510 may be electrically connected to a processor (e.g., the processor 120 in FIG. 1) and/or the wireless communication module 192 disposed on a printed circuit board 340. For example, the protruding part 510 may be electrically connected to the printed circuit board 340 by using a conductive connection member 520. The conductive connection member 520 may include a C-clip, a conductive foam spring, or solder. The conductive connection member 520 may be detachably coupled to the printed circuit board 340 (e.g., the second PCB 340b).

According to an embodiment, the shield member 420 may include an opening part 421. The shield member 420 may not overlap or may not be in contact with at least one fastening member (e.g., the first fastening member 430a and/or the second fastening member 430b) by using the opening part 421.

According to an embodiment, for example, at least one fastening member (e.g., the first fastening member 430a and/or the second fastening member 430b) may fix a USB connector 530 (e.g., the connection terminal 178 in FIG. 1) to a first support member 311 (e.g., the non-conductive member 610 in FIG. 6A). The at least one fastening member (e.g., the first fastening member 430a and/or the second fastening member 430b) may include a metal boss through which at least one fastening hole 431a or 431b is formed.

In an embodiment illustrated in FIG. 5A, for example, although it is illustrated that the opening part 421 included in the shield member 420 has been formed in a predetermined shape (e.g., a T-shape), it is not limited thereto, and the opening part may be formed in various other shapes capable of preventing the shield member 420 and at least one fastening member (e.g., the first fastening member 430a and/or the second fastening member 430b) overlapping or being electrically connected to each other.

Referring to (i) of FIG. 5B, for example, the opening part 421 of the shield member 420 may include a first hole 421a and a second hole 421b corresponding to the first fastening member 430a and the second fastening member 430b. The first hole 421a and the second hole 421b may be disposed to be spaced apart from each other. The first fastening member 430a may be disposed inside the first hole 421a. The first fastening member 430a may not overlap or may not be electrically connected to the shield member 420, by using the first hole 421a. The second fastening member 430b may be disposed inside the second hole 421b. The second fastening member 430b may not overlap or may not be electrically connected to the shield member 420, by using the second hole 421b.

Referring to (ii) of FIG. 5B, for example, the opening part 421 of the shield member 420 may include a slit 421c in which the first fastening member 430a and the second fastening member 430b are arranged. The first fastening member 430a and the second fastening member 430b may be arranged inside the slit 421c. The first fastening member 430a and the second fastening member 430b may be arranged in the slit 421c to be spaced apart from each other. The first fastening member 430a and the second fastening member 430b may not overlap or may not be electrically connected to the shield member 420, by using the slit 421c.

Referring to (iii) of FIG. 5B, for example, the opening part 421 of the shield member 420 may include an opening 421d in which the first fastening member 430a and the second fastening member 430b are arranged and which has one open surface. The first fastening member 430a and the second fastening member 430b may be arranged inside the opening 421d. The first fastening member 430a and the second fastening member 430b may be arranged in the opening 421d to be spaced apart from each other. The first fastening member 430a and the second fastening member 430b may not overlap or may not be electrically connected to the shield member 420, by using the opening 421d.

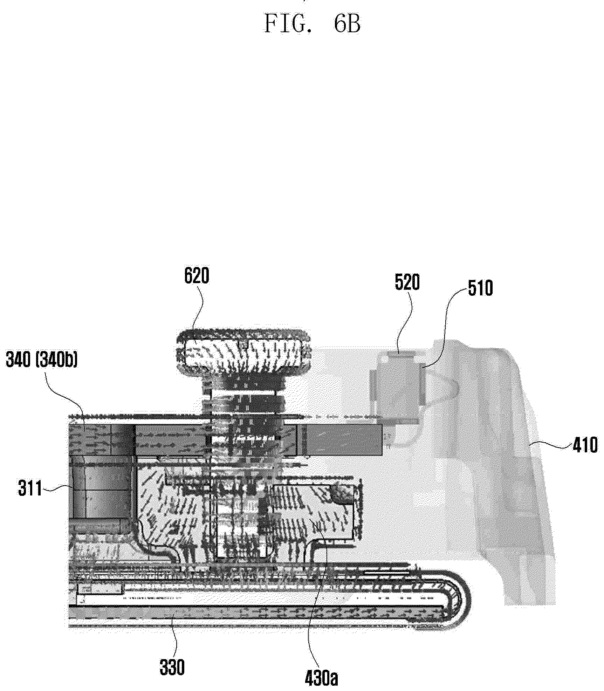

FIG. 6A is a view showing a schematic cross-section of the electronic device taken along line A-A' in FIG. 5A and a current flow according to various embodiments of the disclosure. FIG. 6B is a view showing a simulation result of the distribution of a current flow of the electronic device illustrated in FIG. 6A according to various embodiments of the disclosure. FIG. 6A and FIG. 6B are cross-sectional views of a part of the electronic device in FIG. 5A according to various embodiments of the disclosure when seen in one direction (e.g., the y-axis direction).

Referring to FIG. 6A and FIG. 6B, a fixation member 620 (e.g., a screw or a bolt) according to various embodiments of the disclosure may be coupled to the through-hole 441 formed through the printed circuit board 340 (e.g., the second PCB 340b), and the first fastening hole 431a of the first fastening member 430a disposed in the first support member 311. The first fastening member 430a may be disposed inside the non-conductive member 610 formed in the first support member 311.

According to an embodiment, the conductive portion 410 may be electrically connected to the printed circuit board 340 by using the protruding part 510 and the conductive connection member 520. At least a part of the shield member 420 including the opening part 421 may be disposed on the lower part (e.g., the surface in the -z-axis direction) of a non-conductive member 610 formed in the first support member 311. The shield member 420 may not overlap or may not be in contact with the first fastening member 430a, by using the opening part 421.

According to an embodiment, an emission current may flow in direction ① (e.g., the -x-axis direction) along the printed circuit board 340 (e.g., the second PCB 340b). The current flowing in the direction ① (e.g., the -x-axis direction) may flow in direction ② (e.g., the -z-axis direction) through the fixation member 620.

According to an embodiment, in case that the shield member 420 and the first fastening member 430a are not in contact with or are not coupled to each other, the emission current flowing in the direction (2) (e.g., the -z-axis direction) may not flow in an opposite direction (e.g., the x-axis direction) to the direction of the emission current flowing along the printed circuit board 340 (e.g., the second PCB 340b) by the opening part 421 formed in the shield member 420. As another example, an emission current induced in shield member 420 by the emission current flowing in the printed circuit board 340 may flow in the -x-axis direction (the direction (3)). As another example, an emission current induced in the display 330 by the emission current flowing in the shield member 420 may flow in the -x-axis direction (the direction 40) substantially the same as that of the emission current flowing in the shield member 420.

According to various embodiments, in case that the shield member 420 and the first fastening member 430a are configured so as not to overlap or so as not to be in contact with each other, the emission current flowing in the -x-axis direction (e.g., the direction (D) through the printed circuit board 340 (e.g., the second PCB 340b), the emission current flowing in the -x-axis direction through the opening part 421 formed in the shield member 420, and the emission current flowing in the -x-axis direction (e.g., the direction 40) through the display 330 may flow in substantially the same direction, and thus attenuation may not occur. In this case, the conductive portion 410 may prevent the occurrence of parasitic resonance in the frequency band of a mid-band (e.g., about 1500 MHz - 2200 MHz) and/or a high band (e.g., about 2300 MHz - 2700 MHz), to reduce degradation of radiation performance of the conductive portion 410 and to reduce the occurrence of deviation in the frequency band of the mid-band and/or the high band.

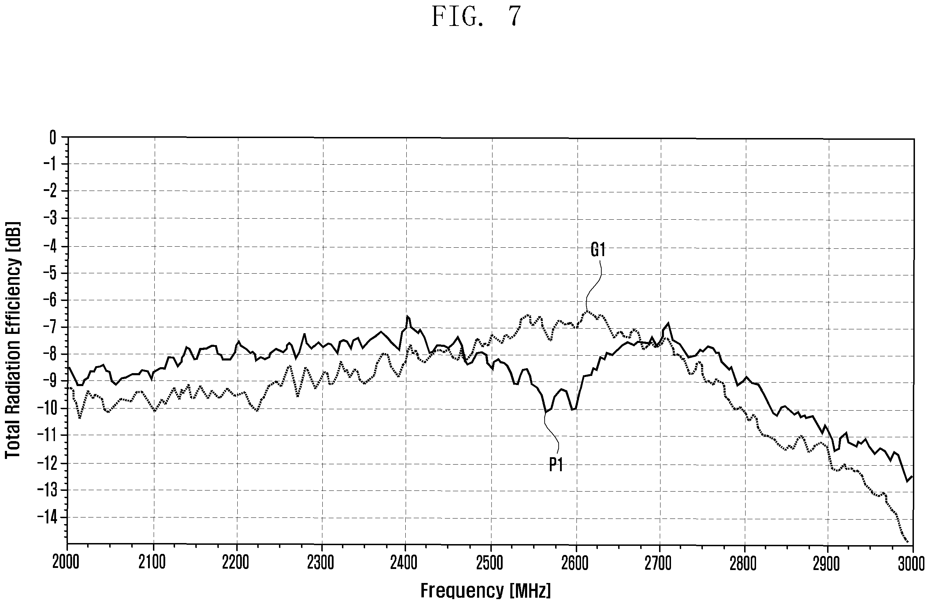

FIG. 7 is a view showing a radiation efficiency of an electronic device according to various embodiments of the disclosure and a radiation efficiency of an electronic device according to a comparative embodiment.

According to various embodiments, the electronic device 400 according to various embodiments of the disclosure may be configured such that the shield member 420 is not overlap or is not in contact with at least one fastening member (e.g., the first fastening member 430a and/or the second fastening member 430b) by using the opening part 421. For example, the shield member 420 may not be electrically connected to at least one fastening member (e.g., the first fastening member 430a and/or the second fastening member 430b).

According to various embodiments, in an electronic device according to a comparative embodiment, a shield member may overlap or may be in contact with at least one fastening member. For example, the shield member 420 may be electrically connected to at least one fastening member (e.g., the first fastening member 430a and/or the second fastening member 430b).

Referring to FIG. 7, it may be identified that the electronic device 400 according to various embodiments of the disclosure has a radiation efficiency G1 in which parasitic components are removed in the band of about 2500 MHz - 2700 MHz, and thus the radiation efficiency thereof has been improved, compared to a radiation efficiency P1 of an electronic device according to a comparative embodiment. For example, it may be identified that the radiation efficiency G1 of the electronic device 400 according to various embodiments of the disclosure is about 1 dB to 3 dB higher in the band of about 2500 MHz - 2650 MHz, compared to the radiation efficiency P1 of the electronic device according to the comparative embodiment.

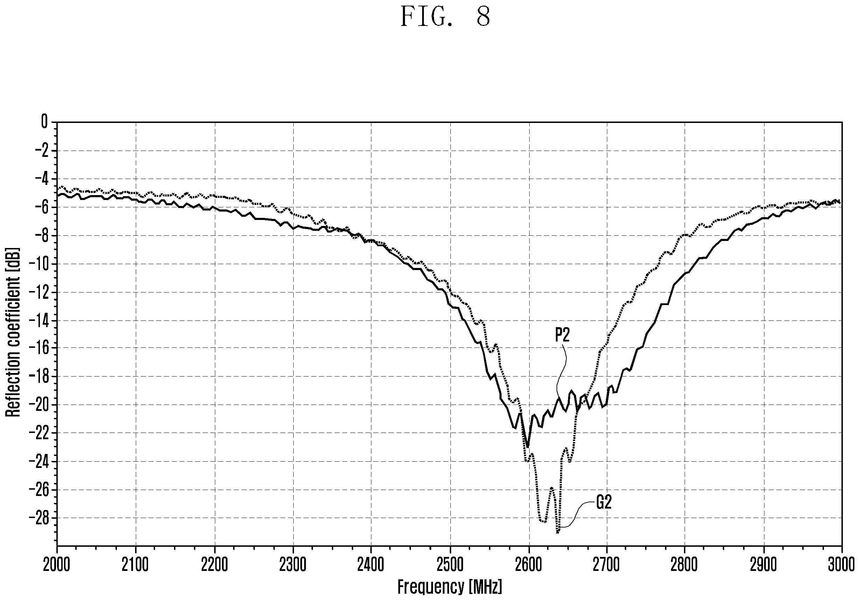

FIG. 8 is a view showing a reflection coefficient of an electronic device according to various embodiments of the disclosure and a reflection coefficient of an electronic device according to a comparative embodiment.

According to various embodiments, the electronic device 400 according to various embodiments of the disclosure may be configured such that the shield member 420 is not overlap or is not in contact with at least one fastening member (e.g., the first fastening member 430a and/or the second fastening member 430b) by using the opening part 421. For example, the shield member 420 may not be electrically connected to at least one fastening member (e.g., the first fastening member 430a and/or the second fastening member 430b).

According to various embodiments, in an electronic device according to a comparative embodiment, a shield member may overlap or may be in contact with at least one fastening member. For example, the shield member 420 may be electrically connected to at least one fastening member (e.g., the first fastening member 430a and/or the second fastening member 430b).

Referring to FIG. 8, it may be identified that the electronic device 400 according to various embodiments of the disclosure has a reflection coefficient G2 being reduced in the band of about 2600 MHz - 2660 MHz, compared to a reflection coefficient P2 of the electronic device according to the comparative embodiment. For example, it may be identified that the reflection coefficient G2 of the electronic device 400 according to various embodiments of the disclosure has been improved by about 2dB - 8dB in the band of about 2610MHz - 2660MHz, compared to the reflection coefficient P2 of the electronic device according to the comparative embodiment.

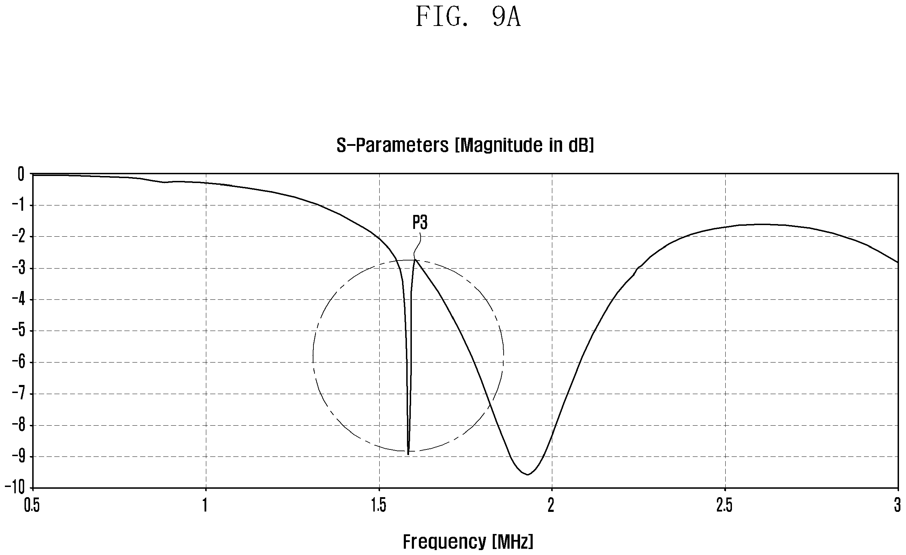

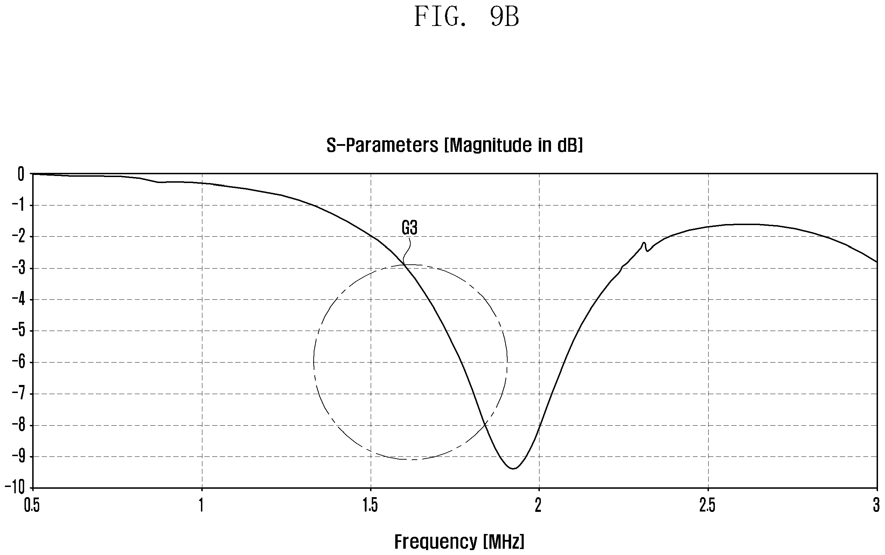

FIG. 9A is a view showing a VSWR simulation result of an electronic device according to a comparative embodiment. FIG. 9B is a view showing a VSWR simulation result of an electronic device according to various embodiments of the disclosure.

Referring to FIG. 9A, in an electronic device according to a comparative embodiment, a shield member may overlap or may be in contact with at least one fastening member. For example, the shield member 420 may be electrically connected to at least one fastening member (e.g., the first fastening member 430a and/or the second fastening member 430b).

According to an embodiment, it may be identified that in case of an electronic device according to a comparative embodiment, parasitic resonance occurs in the band of about 1.6 GHz, and reflection loss occurs, as illustrated as a P3.

Referring to FIG. 9B, the electronic device 400 according to various embodiments of the disclosure may be configured such that the shield member 420 is not overlap at least one fastening member (e.g., the first fastening member 430a and/or the second fastening member 430b) by using the opening part 421.

According to an embodiment, it may be identified that in the electronic device 400 according to various embodiments of the disclosure, parasitic resonance does not occur in the band of about 1.6 GHz, and reflection loss does not occur, as illustrated as a G3, compared to the electronic device according to the comparative embodiment.

An electronic device 400 according to various embodiments of the disclosure may include a housing 310 having a first segment part 401 and a second segment part 402 formed therein and including a conductive portion 410 formed between the first segment part 401 and the second segment part 402, a support member 311 which is disposed inside the housing 310 and includes a metal material and/or non-conductive member 610, a display 330 disposed on a first surface of the support member 311, a printed circuit board 340 which is disposed on a second surface of the support member 311 and includes at least one through-hole 441, a processor (e.g., the processor 120 in FIG. 1) disposed on the printed circuit board 340 and electrically connected to the conductive portion 410, at least one fastening member 430 which is disposed in the non-conductive member 610 and includes a fastening hole 431, and a shield member 420 which is disposed between the display 330 and the support member 311 and has an opening part 421 formed therein, wherein the opening part 421 is formed such that the shield member 420 and the at least one fastening member 430 are not electrically connected.

According to various embodiments, the printed circuit board 340 may include a first PCB 340a disposed in a first direction, and a second PCB 340b disposed in a second direction different from the first direction, and the first PCB 340a and the second PCB 340b may be electrically connected using at least one connection member 345.

According to various embodiments, the shield member may be configured to shield an electromagnetic wave generated from the display and/or the printed circuit board.

According to various embodiments, the at least one through-hole formed through the printed circuit board and the fastening hole formed through the at least one fastening member may be coupled using a fixation member 620 (e.g., a screw or a bolt).

According to various embodiments, the end of the fixation member may be disposed in the opening part of the shield member.

According to various embodiments, the electronic device may include a dielectric structure 450 disposed on at least a part of the printed circuit board and coupled to the support member by using at least one coupling member.

According to various embodiments, the conductive portion may include a protruding part 510 formed on a side of the inside thereof, and the protruding part 510 may be electrically connected to the printed circuit board by using a conductive connection member 520.

According to various embodiments, the at least one fastening member may be configured to fix a USB connector 530 to the support member.

According to various embodiments, the shield member may be configured such that at least a part thereof is disposed on the lower part of the non-conductive member.

According to various embodiments, a current flowing in a first direction along the printed circuit board may flow in a second direction through the fixation member, a current delivered through the fixation member may flow in a direction substantially the same as the first direction by the opening part formed in the shield member to be delivered to the conductive portion, and a current flowing along the display may flow in a direction substantially the same as the first direction through the shield member to be delivered to the conductive portion.

An electronic device 400 according to various embodiments of the disclosure may include a housing 310 having a first segment part 401 and a second segment part 402 formed therein and including a conductive portion 410 formed between the first segment part 401 and the second segment part 402, a support member 311 which is disposed inside the housing 310 and includes a metal material and/or non-conductive member 610, a display 330 disposed on a first surface of the support member 311, a printed circuit board 340 which is disposed on a second surface of the support member 311 and includes at least one through-hole 441, a processor 120 disposed on the printed circuit board 340 and electrically connected to the conductive portion 410, at least one fastening member 430 which is disposed in the non-conductive member 610 and includes a fastening hole 431, and a shield member 420 which is disposed between the display 330 and the support member 311 and has an opening part 421 formed therein, wherein the opening part 421 may be formed such that the shield member 420 and the at least one fastening member 430 are not electrically connected, the at least one through-hole 441 formed through the printed circuit board 340 and the fastening hole 431 formed through the at least one fastening member 430 may be coupled using a fixation member 620, a current flowing in a first direction along the printed circuit board 340 may flow in a second direction through the fixation member 620, and a current delivered through the fixation member 620 may flow in a direction substantially the same as the first direction by the opening part 421 formed in the shield member 420 to be delivered to the conductive portion 410.

According to various embodiments, a current flowing along the display may flow in a direction substantially the same as the first direction through the shield member to be delivered to the conductive portion.

According to various embodiments, the printed circuit board 340 may include a first PCB 340a disposed in a first direction, and a second PCB 340b disposed in a second direction different from the first direction, and the first PCB 340a and the second PCB 340b may be electrically connected using at least one connection member 345.

According to various embodiments, the shield member may be configured to shield an electromagnetic wave generated from the display and/or the printed circuit board.

According to various embodiments, the end of the fixation member may be disposed in the opening part of the shield member.

According to various embodiments, the electronic device may include a dielectric structure 450 disposed on at least a part of the printed circuit board and coupled to the support member by using at least one coupling member.

According to various embodiments, the conductive portion may include a protruding part 510 formed on a side of the inside thereof, and the protruding part 510 may be electrically connected to the printed circuit board by using a conductive connection member 520.

According to various embodiments, the at least one fastening member may be configured to fix a USB connector 530 to the support member.

According to various embodiments, the shield member may be configured such that at least a part thereof is disposed on the lower part of the non-conductive member.

According to various embodiments, the conductive portion may be configured to prevent the occurrence of parasitic resonance in a frequency band of 1500 MHz - 2200 MHz and/or a frequency band of 2300 MHz - 2700 MHz.

In the above, the disclosure has been described according to various embodiments of the disclosure, but it will be apparent that embodiments changed and modified by a person skilled in the technical field pertaining to the disclosure without departing from the technical idea of the present disclosure also fall within the scope of the disclosure.

## Claims

1. An electronic device comprising:
a housing having a first segment part and a second segment part formed therein and comprising a conductive portion formed between the first segment part and the second segment part;
a support member disposed inside the housing and comprising at least one of a metal material and a non-conductive member;
a display disposed on a first surface of the support member;
a printed circuit board disposed on a second surface of the support member and comprising at least one through-hole;
a processor disposed on the printed circuit board and electrically connected to the conductive portion;
at least one fastening member disposed in the non-conductive member and comprising a fastening hole; and
a shield member disposed between the display and the support member and having an opening part formed therein,
wherein the opening part is formed such that the shield member and the at least one fastening member are not electrically connected.

2. The electronic device of claim 1, wherein the printed circuit board comprises:
a first PCB disposed in a first direction; and
a second PCB disposed in a second direction different from the first direction, and
wherein the first PCB and the second PCB are electrically connected using at least one connection member.

3. The electronic device of claim 1, wherein the shield member is configured to shield an electromagnetic wave generated from at least one of the display and the printed circuit board.

4. The electronic device of claim 1, wherein the at least one through-hole formed through the printed circuit board and the fastening hole formed through the at least one fastening member are coupled using a fixation member, and
wherein the end of the fixation member is disposed in the opening part of the shield member.

5. The electronic device of claim 1, further comprising a dielectric structure disposed on at least a part of the printed circuit board and coupled to the support member by using at least one coupling member.

6. The electronic device of claim 1, wherein the conductive portion comprises a protruding part formed on a side of the inside thereof, and
wherein the protruding part is electrically connected to the printed circuit board by using a conductive connection member.

7. The electronic device of claim 1, wherein the at least one fastening member is configured to fix a USB connector to the support member.

8. The electronic device of claim 1, wherein the shield member is configured such that at least a part thereof is disposed on the lower part of the non-conductive member.

9. The electronic device of claim 4, wherein a current flowing in a first direction along the printed circuit board flows in a second direction through the fixation member,
wherein a current delivered through the fixation member flows in a direction substantially the same as the first direction by the opening part formed in the shield member to be delivered to the conductive portion, and
wherein a current flowing along the display flows in a direction substantially the same as the first direction through the shield member to be delivered to the conductive portion.

10. An electronic device comprising:
a housing having a first segment part and a second segment part formed therein and comprising a conductive portion formed between the first segment part and the second segment part;
a support member disposed inside the housing and comprising at least one of a metal material and a non-conductive member;
a display disposed on a first surface of the support member;
a printed circuit board disposed on a second surface of the support member and comprising at least one through-hole;
a processor disposed on the printed circuit board and electrically connected to the conductive portion;
at least one fastening member disposed on the non-conductive member and comprising a fastening hole; and
a shield member disposed between the display and the support member and having an opening part formed therein,
wherein the opening part is formed such that the shield member and the at least one fastening member are not electrically connected,
wherein the at least one through-hole formed through the printed circuit board and the fastening hole formed through the at least one fastening member are coupled using a fixation member,
wherein a current flowing in a first direction along the printed circuit board flows in a second direction through the fixation member, and
wherein a current delivered through the fixation member flows in a direction substantially the same as the first direction by the opening part formed in the shield member to be delivered to the conductive portion.

11. The electronic device of claim 10, wherein a current flowing along the display flows in a direction substantially the same as the first direction through the shield member to be delivered to the conductive portion.

12. The electronic device of claim 10, wherein the printed circuit board comprises:
a first PCB disposed in a first direction; and
a second PCB disposed in a second direction different from the first direction, and
wherein the first PCB and the second PCB are electrically connected using at least one connection member.

13. The electronic device of claim 10, wherein the shield member is configured to shield an electromagnetic wave generated from at least one of the display and the printed circuit board.

14. The electronic device of claim 10, wherein the end of the fixation member is disposed in the opening part of the shield member.

15. The electronic device of claim 10, further comprising a dielectric structure disposed on at least a part of the printed circuit board and coupled to the support member by using at least one coupling member.
